# EUROPEAN PATENT APPLICATION

(11) **EP 0 799 905 A1**
(43) Date of publication of application: **08.10.1997**
(21) Application number: 97105291.5
(22) Date of filing: 27.03.1997
(51) Int. Cl.: C23C 14/34, C22F 1/10

(54) **High-purity cobalt sputtering targets and method of manufacturing the same**

(30) Priority: 05.04.1996 JP 108671/96
(71) Applicant: JAPAN ENERGY CORPORATION, Minato-ku, Tokyo (JP)
(72) Inventor: Kano, Osamu, c/o Japan Energy Corporation, Kitaibaraki-shi, Ibaraki-ken (JP); Yasui, Koichi, c/o Japan Energy Corporation, Kitaibaraki-shi, Ibaraki-ken (JP)
(74) Representative: Schwan, Gerhard, Dipl.-Ing.

(57) **Abstract**

There is provided a high-purity cobalt sputtering target with minimum noxious impurity contents characterized by permeability values of 12 or less in the direction parallel to the sputter surface and 36 or more in the direction perpendicular to the sputter surface. The ratio I₍₀₀₂₎/I₍₁₀₀₎ of the X-ray diffraction peak intensity I₍₀₀₂₎ on the (002) plane of the target to the X-ray diffraction peak intensity I₍₁₀₀₎ on the (100) plane is either I₍₀₀₂₎/I₍₁₀₀₎ ≧ 4 along the sputter surface or I₍₀₀₂₎/I₍₁₀₀₎ < 1 perpendicularly to the surface. In the course of manufacture the crystalline orientation and residual working strain of the target are controlled.

## Description

### BACKGROUND OF THE INVENTION

This invention relates to sputtering targets for thin film deposition, and more specifically to high-purity cobalt sputtering targets for use in magnetron sputtering.

The high-purity cobalt sputtering targets of this invention are suitably used as target materials for forming electrodes and interconnections of VLSI circuits.

Polycrystalline silicon, used for many years as a chief electrode material for semiconductor devices, has been supplanted by silicides of molybdenum, tungsten, etc. with the tendency toward larger scale integration. Utilization of titanium and cobalt silicides is now drawing the attention of the art. Also, attempts are being made to use cobalt as a material for conductive connections in place of the commonly used aluminum and aluminum alloys. These electrodes and connections of cobalt and cobalt silicide are typically formed by sputtering a cobalt target in an argon atmosphere.

In order that a semiconductor member thus formed by sputtering should ensure reliable semiconducting performance, it is important that the member contains a minimum, if any, of metallic impurities noxious for semiconductor devices.
The noxious impurities include:
(1) alkali metals such as Na and K;
(2) radioactive elements such as U and Th; and
(3) transition metals such as Fe, Ni, and Cr.

Alkali metals such as Na and K migrate easily in gate insulator films, which can lead to deterioration of MOS-LSI interface characteristics. Radioactive elements such as U and Th emit alpha rays which can be responsible for soft errors of semiconductor components. Heavy metals such as Fe, Ni, and Cr too can cause troubles of interface connections.

By the way, cobalt, which is a ferromagnetic material, is subjected to a phenomenon of a target of cobalt being magnetized when put in a place where a magnetic field exists.

Sputtering today is in most cases carried out by a technique known as "magnetron sputtering" which does not merely involve the bombardment of a target by Ar⁺ but accelerates Ar⁺ concentration with the help of a magnetic field. It means that a cobalt target is under the influence of the magnetic field in the sputtering system.

The principle of magnetron sputtering consists in setting a magnet at the back of a target to produce a magnetic field on the front side of the target, and then capturing Ar⁺ ion by dint of the magnetic field. The efficiency of Ar⁺ capture depends on how strong a magnetic field can be produced on the target surface.

Being a ferromagnetic material, the target is internally magnetized, allowing lines of magnetic force to run through its inside where reluctance is low. The internal magnetization thus reduces the number of lines that pass through to the target surface and impairs the effective Ar⁺ capturing efficiency. Hence it poses the problem of low sputtering rate, the inevitable of a ferromagnetic target.

In an effort to cope with this problem of a ferromagnetic target while in use, it has been in practice to reduce the thickness of the target and enlarge the magnetic field that leaks out to the target surface. This practice entails early wear and frequent replacement of the target. Among other drawbacks is a low utilization efficiency due to localized wear.

Japanese Patent Application Kokai No. 63-227775 aims at decreasing the permeability of ferromagnetic targets. To that end, it teaches performing plastic working up to 50 % at the final stage of forming operation to leave the deformation texture behind and increase the internal stresses of the product target. Cobalt alloys and ferrous alloys are cited as examples of target materials.

However, the proposal of plastic working up to 50 % at the end of forming operation to leave a deformation texture and increase the internal stresses of the product target thereby to reduce its permeability, is too rough and broad to meet the future demand for high-purity cobalt sputtering targets. Also, there is a great likelihood of growing requirement for targets with increased thickness. It is because a thick cobalt sputtering target develops no camber and works efficiently; these are major advantages to both the manufacturer and the user. In particular, with a high-purity cobalt target, the high material cost makes the efficient thick target advantageous.

It is an object of this invention, which is directed to high purity cobalt sputtering targets, to establish a technique for manufacturing high-purity cobalt sputtering targets suited for use in magnetron sputtering, with high sputtering rate and excellent target utilization efficiency.

Another object of this invention is to provide thick, high-purity cobalt sputtering targets ranging in thickness from 3.0 to 6.36 mm, typically from 4 to 6.35 mm.

### BRIEF SUMMARY OF THE INVENTION

It has now been found, after our intensive efforts, that the problems of the prior art can be solved by working a high-purity cobalt ingot under certain specific conditions to form, without recrystallization, a target still retaining a deformation texture, with its permeability controlled so as to be within a specific low range in the direction parallel to a sputter surface and within a specific high range in the direction perpendicular to the surface, and particularly with its crystalline orientation controlled so that the ratio, I₍₀₀₂₎/I₍₁₀₀₎, of the X-ray diffraction peak intensity I₍₀₀₂₎ on the (002) plane to the X-ray diffraction peak intensity I₍₁₀₀₎ on the (100) plane, is within a specific range. The discovery produces a marked improvement over the Patent Application Kokai No. 63-227775 that taught mere plastic working up to 50 % at the final stage of forming operation so as to leave the deformation structure behind in the target.

On the basis of the above discovery, this invention provides:
(1) A high-purity cobalt sputtering target for thin film deposition characterized in that the permeability of the target is controlled so as to be less than or equal to 12 in the direction parallel to a sputter surface and greater than or equal to 36 in the direction perpendicular to the surface; and
(2) A high-purity cobalt sputtering target for thin film deposition characterized in that the permeability of the target is controlled so as to be less than or equal to 12 in the direction parallel to a sputter surface and greater than or equal to 36 in the direction perpendicular to the surface, with the ratio, I₍₀₀₂₎/I₍₁₀₀₎, of the X-ray diffraction peak intensity I₍₀₀₂₎ on the (002) plane to the X-ray diffraction peak intensity I₍₁₀₀₎ on the (100) plane being either I₍₀₀₂₎/I₍₁₀₀₎ ≧ 4 on the sputter surface or I₍₀₀₂₎/I₍₁₀₀₎ < 1 on the surface perpendicular to the sputter surface.

The high-purity cobalt sputtering target according to (1) or (2) above consists of, preferably, up to 0.05 ppm sodium, up to 0.05 ppm potassium, up to 10 ppm each iron, nickel, and chromium, up to 0.1 ppb uranium, up to 0.1 ppb thorium, desirably up to 50 ppm carbon, desirably up to 100 ppm oxygen, and the remainder cobalt and unavoidable impurities.

The high-purity cobalt sputtering target according to (1) or (2) above may have a thickness ranging from 3.0 to 6.36 mm.

Further, this invention provides a method of manufacturing a high-purity cobalt sputtering target for thin film deposition characterized by the steps of plastically working a high-purity cobalt ingot at from 1100 to 1200 °C and then (A) cold working, (B) warm working at a temperature below 450 °C, or (C) cold working and then warm working at a temperature below 450 °C, to form a deformation texture and finally, without recrystallization, forming a target directly with the deformation texture.

### BRIEF DESCRIPTION OF THE DRAWINGS

FIG. 1 shows a X-ray diffraction pattern on the sputter surface of the target in Example 1.

FIG. 2 shows a X-ray diffraction pattern on the surface perpendicular to the sputter surface of the target in Example 1.

FIG. 3 shows a X-ray diffraction pattern on the sputter surface of the target in Comparative Example 1.

FIG. 4 shows a X-ray diffraction pattern on the surface perpendicular to the sputter surface of the target in Comparative Example 1.

### DETAILED DESCRIPTION OF THE INVENTION

The term "high-purity cobalt" as used herein means cobalt with a purity of 99.99 % or more, preferably 99.999 %, thus containing a minimum, if any, of impurities noxious for semiconductor devices. It should have the least possible contents of alkali metals such as Na and K, radioactive elements such as U and Th, and transition metals such as Fe, Ni, and Cr. Alkali metals such as Na and K migrate easily in gate insulators, leading to deterioration of MOS-LSI interface characteristics. Radioactive elements such as U and Th emit alpha rays responsible for soft errors of semiconductor components. Heavy metals such as Fe, Ni, and Cr too can cause interface connection troubles.

The target preferably includes up to 0.05 ppm sodium, up to 0.05 ppm potassium, up to 10 ppm each iron, nickel, and chromium, up to 0.1 ppb uranium, up to 0.1 ppb thorium, and the remainder cobalt and unavoidable impurities.

Cobalt of such a high purity can be obtained, e.g., by an electrorefining technique as taught in Patent Application Kokai No. 6-192874, any of combined electrorefining-solvent extraction processes as in Patent Application Kokai Nos. 6-192879 and 7-3468, a combination of anion exchange and either electrowinning or electrorefining as in Patent Application No. 7-80830 or 7-80831. Where necessary, the process may be followed by vacuum melting such as electron beam melting.

For example, Patent Application No. 7-80831 proposes the manufacture of high-purity cobalt by electrorefining, with subsequent vacuum melting such as EB melting as needed. This refining process comprises contacting an aqueous cobalt chloride solution with a hydrochloric acid having a concentration of 7 to 12N with an anion exchange resin for adsorption of cobalt, eluting cobalt from the resin using 1 to 6N hydrochloric acid, evaporating the resulting aqueous solution to dryness or concentrating the same, forming an aqueous solution of high-purity cobalt chloride with pH 0 to 6, and carrying out electrorefining using the aqueous solution as the electrolyte.

Carbon, oxygen, and other gaseous contents in targets are considered undesirable because they raise the electric resistance of the film formed by deposition and have adverse effects upon the surface profile or configuration of the film. It was found that during the course of electrorefining certain organic matter can dissolve out in small amounts from the anion exchange resin, mix with the electrolyte solution, and the mixture in the form of carbon, oxygen, and other gaseous components can find its way into the target. When the anion exchange-electrorefining process is combined with activated carbon treatment and followed, where necessary, by vacuum melting, the gaseous contents of carbon, oxygen and the like are reduced as well as alkali metals, radioactive elements, and transition metals as impurities. Thus it is now possible to manufacture high-purity cobalt for sputtering targets in a large quantity, easily in stable operation at low cost. In this way a high-purity cobalt sputtering target is obtained which comprises up to 0.05 ppm sodium, up to 0.05 ppm potassium, up to 10 ppm each iron, nickel, and chromium, up to 0.1 ppb uranium, up to 0.1 ppb thorium, up to 50 ppm, preferably up to 10 ppm, carbon, up to 100 ppm oxygen, and the remainder cobalt and unavoidable impurities.

In order that the high-purity cobalt thus obtained may have a permeability range as desired, it is only necessary to control its crystalline orientation (deformation texture) and residual working strain amount.

### (1) Crystalline orientation (deformation texture)

A texture of material that exhibits highly anisotropic orientation immediately after cold working is known as a deformation or working texture. Cobalt, with a hexagonal structure at ordinary temperature, can be made anisotropic by certain working. To be more concrete, it is possible to create a deformation texture in which the (002) crystallographic plane along the rolled surface is highly oriented and the (100) plane perpendicular to the (002) plane, or vertical to the rolled surface, is also highly oriented. It is known, by the way, that the degree to which a given material is magnetized, in terms of the atomic level, varies with the crystallographic directions. In view of this, the end is attained by working the material in such way that the easily magnetizable direction (where the permeability µ is high) agrees with the direction perpendicular to the sputter surface and the hardly magnetizable direction (where the permeability µ is low), parallel to the sputter surface. In other words, the material has only to be worked under orientation control such that the easily magnetizable direction of cobalt, or the direction of the 〈002〉 axis, comes to be perpendicular to the sputter surface and the hardly magnetizable direction, the 〈101〉 or 〈100〉 axis direction, parallel to the sputter surface. It is important with cobalt to take the advantage of the orientation of its deformation texture that is suited for the permeability control under the invention, i.e., to use it as it is, without heat treatment, thus retaining its deformation texture. (If instead it is heat treated at a given temperature after cold rolling, cobalt will no longer have the deformation texture but will obtain a recrystallization structure with a different orientation. This would be unwarranted for the purpose of permeability control at which the invention is aimed.)

The target so manufactured is desired to have a ratio, I₍₀₀₂₎/I₍₁₀₀₎, of the X-ray diffraction peak intensity I₍₀₀₂₎ on the (002) plane to the X-ray diffraction peak intensity I₍₁₀₀₎ on the (100) plane, of either I₍₀₀₂₎/I₍₁₀₀₎≧ 4 on the sputter surface or I₍₀₀₂₎/I₍₁₀₀₎ < 1 on the surface perpendicular to the sputter surface.

Thus, the deformation texture (crystalline orientation) inherent in cobalt is utilized to control the permeability values of the resulting target; to be less than or equal to 12 in the direction parallel to a sputter surface and greater than or equal to 36 in the direction perpendicular to the surface.

### (2) Working strain

To dispense with heat treatment means leaving the working strain unremoved. The working strain too is contributory to the reduction of permeability. Magnetization of material generally involves the movement and rotation of domain walls. Working strain and induced dislocation act to hamper the movement and rotation. The crystalline orientation being the same, the strain-free state and the strained state differ in the permeability value, and internal strain reduces the permeability sharply.

A target with desired permeability can, therefore, be made by making the most of the deformation texture in which the (002) plane along the rolled surface is highly oriented and the (100) plane perpendicular to the (002) plane, or vertical to the rolled surface, is also highly oriented, and, without prior heat treatment, machining the deformation texture as it is, with the working strain left unremoved.

In accordance with the invention, a target is manufactured by a sequence of operations on an ingot formed by electron beam melting; hot forging, hot rolling, descaling (removing surface oxides), cold rolling or reheating to a suitable temperature and warm rolling to a target thickness, machining (circumferential and surface machining) to the final target dimensions, and bonding. The sequence, of course, is not limited to the steps mentioned, but many variations are possible. For example, the hot forging may be replaced by hot rolling. Also, after descaling, the cold rolling may be done, e.g., to 20 % of the objective thickness reduction, followed by warm rolling at 400 °C down to the final thickness. The last-mentioned procedure is highly effective for permeability control.

Thus, a high-purity cobalt sputtering target with a permeability of less than or equal to 12 in the direction parallel to a sputter surface and greater than or equal to 36 in the direction perpendicular to the surface is manufactured in two ways: (1) plastically working (forging or rolling) a high-purity cobalt ingot at from 1100 to 1200 °C, cold working or warm working below 450 °C, and thereafter, without recrystallization, forming a target directly with the deformation texture, or (2) plastically working (forging or rolling) a high-purity cobalt ingot at from 1100 to 1200 °C, cold working and warm working below 450 °C, and thereafter, without recrystallization, forming a target directly with the deformation texture. The warm working temperature is specified to be below 450 °C, because a higher temperature can undesirably transform the deformation texture into a recrystallization texture.

Controlling the crystalline orientation and working strain in the ways described above and setting the permeability values within the desired ranges render it possible to enlarge the magnetic field that leaks out to the sputter surface of the target. This in turn leads to improvements in the sputtering rate and the efficiency of target utilization. In addition, thicker targets than heretofore, of 3.0 mm or greater thickness, particularly between 3.5 mm and 6.36 mm or even more, can be obtained.

### EXAMPLES

### (Example 1)

A high-purity cobalt ingot with reduced impurity contents (measuring 80 mm dia. and 120 mm long) was made by electrorefining and EB melting. The high-purity cobalt ingot so obtained was heated to 1150 °C and forged to a shape of 240 mm square and 10 mm thick. This forged plate was heated to 1100 °C, hot rolled to 295 mm square and 6.5 mm thick, lightly freed from a surface oxide layer by a grinder, and cold rolled to a thickness of 5.0 mm. The rolled sheet with orientation thus controlled was directly machined, without prior heat treatment, to a blank target (300 mm dia.). The blank was lightly faced on both sides, and at the point when the sheet was 4 mm thick, it was bonded to a backing sheet. The bonding was followed by further facing of the target surface to obtain a 3 mm-thick sputtering target. The final facing has to be preceded by bonding to the backing sheet, because facing to the eventual thickness of 3 mm before bonding would warp the target to an unbondable degree.

### (Example 2)

The same EB-melted ingot as used in Example 1 was hot forged and hot rolled in the same manner. After descaling, the work was warm rolled at 400 °C to a thickness of 5 mm. The rolled sheet thus controlled in orientation, without subsequent heat treatment, was finished in the manner described in Example 1 to a 3 mm-thick sputtering target.

### (Example 3)

The EB-melted ingot of Example 1 was hot forged to dimensions of 240 mm square and 10 mm thick and hot rolled to 268 mm square and 8 mm thick. The work was descaled, cold rolled to a 7.7 mm thickness, and warm rolled at 400 °C to 5 mm thick. The rolled sheet with controlled orientation was finished without heat treatment, as in Example 1, to a 3 mm-thick sputtering target.

### (Example 4)

Here is illustrated an example of manufacturing a 4.0 mm-thick target. An EB ingot 80 mm dia. and 138 mm long was made. It was hot forged to a plate 240 mm square and 12 mm thick, hot rolled to 292 mm square and 8.1 mm thick, descaled, cold rolled to 330 mm square and 6.1 mm thick, and finally, without heat treatment, it was finished to a 4.0-mm thick target.

### (Example 5)

Another example of manufacture of a 4.0 mm-thick target is given. An EB ingot 80 mm dia. and 138 mm long was made, and it was hot forged and hot rolled to a plate 260 mm square and 10 mm thick. After descaling, the plate was cold rolled to 290 mm square and 7.7 mm thick, warm rolled at 400 °C to a thickness of 6 mm, and then, without heat treatment, it was finished to a target 4.0 mm thick.

### (Example 6)

This is an example of manufacture of a 6.35 mm-thick target. An EB ingot 80 mm dia. and 175 mm long was made and hot forged and hot rolled to a plate 260 mm square and 13 mm thick. The plate was descaled, cold rolled to 290 mm square and 10 mm thick, warm rolled at 400 °C to a thickness of 8.2 mm, and was finished without heat treatment to a target 6.35 mm thick.

### (Example 7)

A high-purity cobalt ingot whose gaseous impurity contents were reduced as well as solid impurities was made by anion exchange-electrorefining process combined with an activated carbon treatment and followed by EB melting. This EB ingot was worked in the same way as described in Example 1 and was made into a similar 3 mm-thick sputtering target.

### (Comparative Example 1)

Similarly to Example 1, a high-purity cobalt ingot (80 mm dia. and 120 mm long) with reduced impurity contents was made by electrorefining and EB melting. The high-purity cobalt ingot was heated to 1150 °C and forged to a plate 240 mm square and 10 mm thick. This forged plate was heated to 1100 °C and hot rolled to 295 mm square and 6.5 mm thick, and after light removal of its surface oxide layer by a grinder, the work was cold rolled to a thickness of 5.0 mm. The cold rolled sheet was heat treated at 850 °C. After the heat treatment, the sheet was machined in the manner described in Example 1 to a target diameter (300 mm dia.), lightly ground on both sides to a thickness of 4 mm, when it was bonded to a backing plate. Following the bonding, the target surface was further machined and finished till a 3 mm-thick sputtering target was obtained. This example differs in procedure from Example 1 in that the cold rolling was followed by the heat treatment at 850 °C.

### (Results)

The sputtering targets thus obtained were analyzed for their impurity contents. The results are given in Table 1.

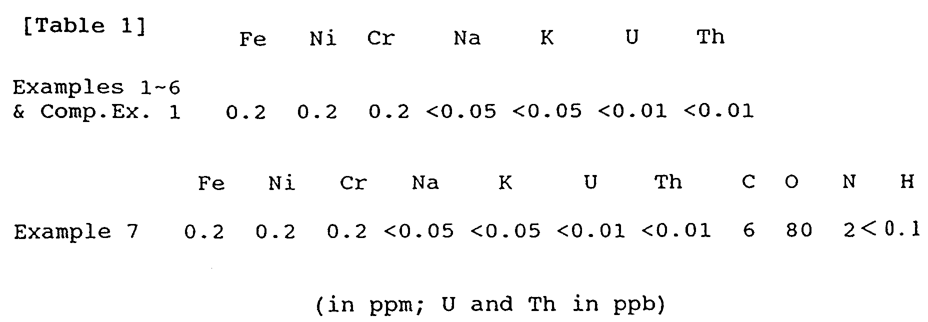

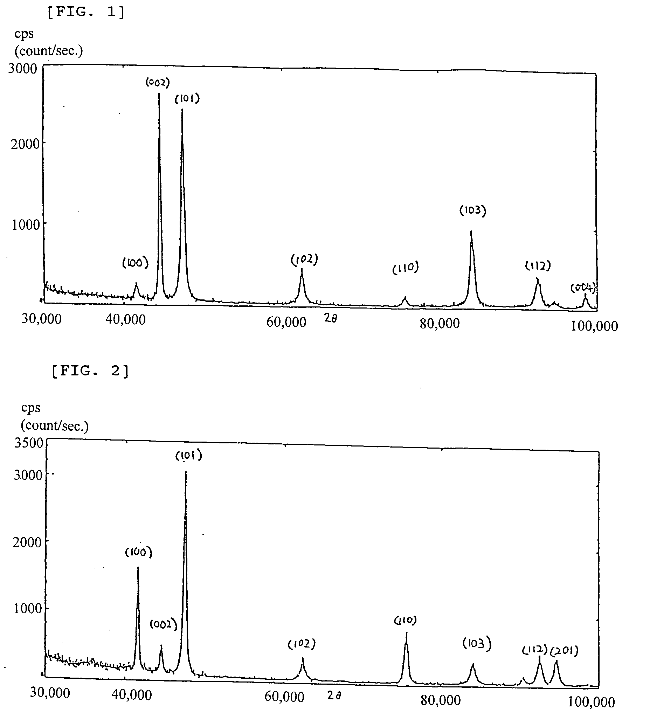

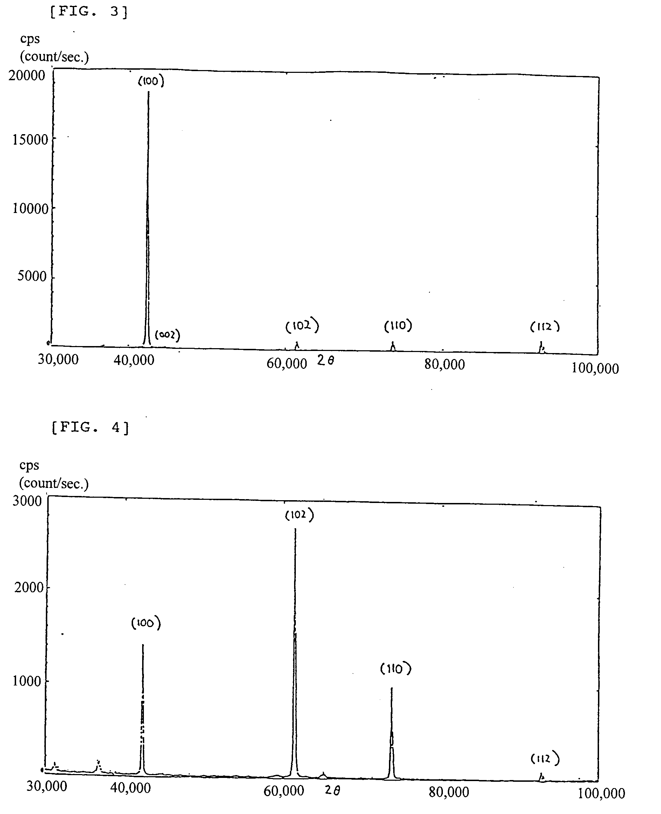

With the target of Example 1, its X-ray diffraction pattern of crystallographic planes along the sputter surface is shown in FIG. 1 and its pattern perpendicular to the sputter surface in FIG. 2. With the target of Comparative Example 1, its X-ray diffraction pattern along the sputter surface is shown in FIG. 3 and its pattern perpendicular to the surface in FIG. 4.

With the sputtering targets of Examples 1 through 7 and Comparative Example 1, their permeabilities in the direction parallel to, and perpendicular to, the sputter surfaces were measured. Also, the ratios, I₍₀₀₂₎ / I₍₁₀₀₎, of the X-ray diffraction peak intensity I₍₀₀₂₎ on the (002) plane to the X-ray diffraction peak intensity I₍₁₀₀₎ on the (100) plane were measured. Table 2 shows the results.

Further, the sputtering targets of Examples 1 through 7 and Comparative Example 1 were used in magnetron sputtering and tested for their film deposition capacities. Their sputtering rates achieved in sputtering runs under identical conditions are compared in Table 3. As for the sputtering conditions, the gas pressure used was 0.5 Pa (3.8 mtorrs) and sputtering power was 3.0 W/cm².

**[Table 2]**

| Target permeability and orientation values | | | | |
|---|---|---|---|---|
| | µ (parallel to the sputter surface) | µ (perpendicular to the sputter surface) | I₍₀₀₂₎/I₍₁₀₀₎ (along the sputter surface) | I₍₀₀₂₎/I₍₁₀₀₎ (perpendicular to the sputter surface) |
| Example 1 | 10.0 | 50.0 | 18.0 | 0.30 |
| Example 2 | 11.5 | 45.0 | 12.0 | 0.50 |
| Example 3 | 7.0 | 55.0 | 24.0 | 0.25 |
| Example 4 | 10.0 | 50.0 | 18.0 | 0.30 |
| Example 5 | 7.0 | 55.0 | 25.0 | 0.25 |
| Example 6 | 7.0 | 55.0 | 26.0 | 0.25 |
| Example 7 | 10.0 | 50.0 | 18.0 | 0.30 |
| Comp.Ex.1 | 30.0 | 28.0 | <0.1 | <0.1 |

**[Table 3]**

| Sputtering rates | | |
|---|---|---|
| | Sputtering rate, Å/sec | Remarks |
| Example 1 | 13 | Film deposition on mass production line possible. |
| Example 2 | 11 | Film deposition on mass production line possible. |
| Example 3 | 18 | Film deposition on mass production line possible. |
| Example 4 | 8 | Film deposition on mass production line possible. |
| Example 5 | 10 | Film deposition on mass production line possible. |
| Example 6 | 6 | Film deposition on mass production line possible. |
| Example 7 | 13 | Film deposition on mass production line possible. |
| Comp.Ex.1 | <1 | Film deposition practically impossible. |
| Note: Cobalt sputters slowly compared with nonmagnetic targets. However, the Co films required generally are thin enough to justify the use of such sputtering rates as listed here for ordinary production lines. | | |

A 30 nm-thick film was deposited using the target of Example 7, and its electric resistance was determined to be 35µ Ω · cm as deposited. The film upon annealing at 700°C exhibited a low resistance of 10µ Ω · cm.

The high-purity cobalt sputtering targets for thin film deposition according to this invention achieve high sputtering rates because their permeabilities in the direction parallel to the sputter surface are made low and in the direction perpendicular to the surface high. Localized wear is reduced and hence the efficiency of target utilization is great. Since it is possible to increase the thickness, the targets are free of the warping problem and call for less frequent replacement. The extremely low impurity levels make the targets suitable for use in forming electrodes and interconnections of VLSI circuits.

## Claims

1. A high-purity cobalt sputtering target for thin film deposition characterized in that the permeability of the target is controlled so as to be less than or equal to 12 in the direction parallel to a sputter surface and greater than or equal to 36 in the direction perpendicular to the surface.

2. A high-purity cobalt sputtering target for thin film deposition characterized in that the permeability of the target is controlled so as to be less than or equal to 12 in the direction parallel to a sputter surface and greater than or equal to 36 in the direction perpendicular to the surface, with the ratio, I₍₀₀₂₎/I₍₁₀₀₎, of the X-ray diffraction peak intensity I₍₀₀₂₎ on the (002) plane to the X-ray diffraction peak intensity I₍₁₀₀₎ on the (100) plane being either I₍₀₀₂₎ /I₍₁₀₀₎ ≧ 4 on the sputter surface or I₍₀₀₂₎/I₍₁₀₀₎ < 1 on the surface perpendicular to the sputter surface.

3. A sputtering target according to claim 1 or 2 wherein the target consists of up to 0.05 ppm sodium, up to 0.05 ppm potassium, up to 10 ppm each iron, nickel, and chromium, up to 0.1 ppb uranium, up to 0.1 ppb thorium, and the remainder cobalt and unavoidable impurities.

4. A sputtering target according to claim 1 or 2 wherein the target consists of up to 0.05 ppm sodium, up to 0.05 ppm potassium, up to 10 ppm each iron, nickel, and chromium, up to 0.1 ppb uranium, up to 0.1 ppb thorium, up to 50 ppm carbon, up to 100 ppm oxygen, and the remainder cobalt and unavoidable impurities.

5. A sputtering target according to any of claims 1 to 4 wherein the thickness of the target ranges from 3.0 mm to 6.36 mm.

6. A method of manufacturing a high-purity cobalt sputtering target for thin film deposition that is defined in any of claims 1 to 5, characterized by the steps of plastically working a high-purity cobalt ingot at from 1100 to 1200 °C and cold working to form a deformation texture and thereafter, without recrystallization, forming a target directly with the deformation texture.

7. A method of manufacturing a high-purity cobalt sputtering target for thin film deposition that is defined in any of claims 1 to 5, characterized by the steps of plastically working a high-purity cobalt ingot at from 1100 to 1200 °C and warm working at a temperature below 450 °C to form a deformation texture and thereafter, without recrystallization, forming a target directly with the deformation texture.

8. A method of manufacturing a high-purity cobalt sputtering target for thin film deposition that is defined in any of claims 1 to 5, characterized by the steps of plastically working a high-purity cobalt ingot at from 1100 to 1200 °C, cold working and then warm working at a temperature below 450 °C to form a deformation texture and finally, without recrystallization, forming a target directly with the deformation texture.
